# EUROPEAN PATENT APPLICATION

(11) **EP 1 995 797 A2**
(43) Date of publication of application: **26.11.2008**
(21) Application number: 08156635.8
(22) Date of filing: 21.05.2008
(51) Int. Cl.: H01L 39/14, H01L 39/24

(54) **Superconductive wire and method for producing the same**

(30) Priority: 21.05.2007 JP 2007133851
(71) Applicant: Hitachi Ltd., Chiyoda-ku Tokyo 100-8280 (JP)
(72) Inventor: Takahashi, Masaya, Tokyo 100-8220 (JP); Tanaka, Kazuhide, Tokyo 100-8220 (JP); Okada, Michiya, Tokyo 100-8220 (JP)
(74) Representative: Leszczynski, André

(57) **Abstract**

A superconductive wire wherein the superconductive wire has a core portion (40) containing magnesium diboride as the main component and a continuous metallic sheath firmly adhered to the core portion (40); the core portion (40) is kept substantially vacuum; and the content of an inert gas such as an Ar gas contained in the core portion is in the range of 0.00002 to 10 ppm. Further, disclosed is a method for producing a superconductive wire, wherein the method comprises the steps of mixing powder of a source material constituting magnesium diboride to form a core portion (40) of the superconductive wire in an inert gas, filling a pipe with the mixed material powder in vacuum environment, sealing the pipe with vacuum after filled with the material powder, forming magnesium diboride powder by heating the vacuum-sealed pipe (sheath), and forming the core portion (40) by wiredrawing the pipe in the state where the magnesium diboride powder is sealed with vacuum, and the core portion (40) firmly sticks to the wiredrawn metallic pipe. The core portion (40) is kept vacuum, and the content of an inert gas contained in the core portion (40) is in the range of 0.00002 to 10 ppm.

## Description

### FIELD OF THE INVENTION

The present invention relates to a magnesium diboride superconductive wire and a method for producing the wire.

### RELATED ART

As a superconductive wire for example, a superconductive wire having a core portion comprising magnesium diboride (hereunder abbreviated to MgB₂) or the like is known.

An MgB₂ superconductive wire is produced by: filling a metallic sheath with MgB₂ powder or mixture of Mg powder and B powder; and wiredrawing the filled metallic sheath.

Consequently, in order to produce a long MgB₂ superconductive wire while the excellent superconductive characteristics is maintained, it is important: to unite MgB₂ with which a metallic sheath is filled with a high degree of purity; and further to uniform MgB₂ in the longitudinal direction.

In a conventional method, in order to produce an MgB₂ superconductive wire having excellent superconductive characteristics, a metallic sheath comprising an outer metallic pipe made of Cu and an inner metallic pipe made of Nb is: filled with Mg + B powder mixed in a ball mill in an Ar gas; and wiredrawn with a drawbench. In the method, the core portion of MgB₂ is densified by uniformly reducing the sectional area of the whole metallic sheath with a drawbench or the like while a longer wire is formed.

Further, the MgB₂ core portion is densified by increasing the filling weight of MgB₂ powder or Mg + B powder with which a metallic sheath is filled in an Ar gas. That is, in a conventional method, an MgB₂ superconductive wire is produced by carrying out powder filling, conditioning, and others in an Ar gas.

JP-A No. 319107/2004 or the like for example is nominated as a patent document wherein a magnesium diboride superconductive wire is produced by the above-mentioned method.

Further, a method for filling a pipe with material powder in vacuum or inert gas in order to prevent magnesium diboride or the source material thereof from oxidizing, and thus prevent the characteristics from being deteriorated is described in JP-A No. 63769/2005.

Moreover, not in the case of a magnesium diboride superconductive material but in the case of a superconductive oxide material, a technology of sealing in a vacuum a billet filled with a superconductive material in a vacuum (JP-A No. 131927/1994) and a technology of drawing a metallic pipe filled with a metallic superconductive material in a vacuum (JP-A No. 203667/1994) are disclosed.

By the above methods however, since powder filling, conditioning, and others are carried out in an Ar gas, an oxidizing gas existing in the Ar gas: intrudes during filling; oxidizes Mg, B, and MgB₂; and thus deteriorates superconductive characteristics.

Further, since powder filling, conditioning, and others are carried out in Ar gas, a large volume of the Ar gas intrudes during filling and the content or the volume of the gas contained during initial filling is inhomogenized by location. As a result, fluidity deteriorates and densification is uneven during wiredrawing, characteristics deteriorate, and a burn-out rate increases.

Although the influence can be reduced by applying area reduction working further, the content and the volume of the gas once contained cannot be controlled and hence it is difficult to eliminate the influence on the characteristics and the lengthening of an MgB₂ wire. In the event of a finer wire, the burn-out rate thereof also increases during the production of the wire.

In the meantime, in the production method by increasing the filling factor of powder, a current initial powder filling factor is about 60% and it is difficult to further improve the filling factor. The reason is that, since the filling powder is fine, fluidity lowers, the powder is bulky at filling, and hence the powder is hardly densified. Further, since a gas component is involved at the same time, the filling of the powder is further difficult. Even if the filling is successful, the filling is dense, thus a necessary fluidity of the powder is not ensured during wiredrawing, and hence the probability of wire breakage during the wiredrawing is presumably very high. Consequently, it is presumably difficult to produce an MgB₂ superconductive wire by increasing the initial powder filling factor. In order to increase an initial powder filling factor, it is effective to fill a pipe with Mg powder and B powder as the source material of magnesium diboride or magnesium diboride in an inert gas such as an Ar gas. When the inert gas remains in large quantity in a filled superconductive material however, the inert gas is harmful and hence it is necessary to replace the inert gas with a vacuum before wiredrawing. Then it is necessary to check the volume of the remaining inert gas in the superconductive wire so as to be 0.00002 to 10 ppm.

### SUMMARY OF THE INVENTION

In view of the above situation, it is desired to reduce the content of a gas that causes wire breakage and the deterioration of performance related to critical current when a long superconductive wire is produced.

An object of the present invention is to provide a superconductive wire of a reduced gas content and a production method thereof.

The present invention provides a superconductive wire wherein: the superconductive wire has a core portion containing magnesium diboride as the main component and a continuous metallic sheath firmly adhered to the core portion; the core portion is kept substantially vacuum; and the content of an inert gas contained in the core portion is in the range of 0.00002 to 10 ppm. It is desirable that the inert gas is an Ar gas.

Further, the present invention provides a method for producing a superconductive wire, wherein: the method comprises the steps of mixing powder of a source material (hereunder referred to as material powder) constitutingmagnesium diboride to form a core portion of the superconductive wire in an inert gas, filling a pipe with the mixed material powder in a vacuum environment, sealing the pipe with a vacuum after filled with the material powder, forming magnesium diboride powder by heating the vacuum-sealed pipe, and forming the core portion by wiredrawing the pipe in the state where the magnesium diboride powder is sealed with a vacuum; and thereby the core portion firmly sticks to the wiredrawn metallic pipe, the core portion is kept substantially vacuum, and the content of an inert gas contained in the core portion is in the range of 0.00002 to 10 ppm.

The content of Ar in the vacuum sheath is conducted in the following manner.
(1) Concentrations of gases in the vacuum sheath are calculated from a vacuum degree.
(2) Amounts of water and oxygen are subtracted from the total gas concentration.
(3) The residual amount of gas is Ar concentration.

Furthermore, the present invention provides, as another embodiment, a method for producing a superconductive wire, which comprises the steps of filling a pipe with powder containing magnesium diboride as the main component to form a core portion of the superconductive wire in an inert gas, replacing the inert gas in the pipe with a vacuum, sealing the metallic pipe with a vacuum after filling the pipe with the powder containing magnesium diboride as the main component and replacing the inert gas with a vacuum, and forming the core portion containing the magnesium diboride as the main component by wiredrawing the metallic pipe in the state where the powder containing the magnesium diboride as the main component is sealed with a vacuum; and thereby the core portion firmly sticks to the wiredrawn metallic pipe, the core portion is kept substantially vacuum, and the content of the inert gas contained in the core portion is in the range of 0.00002 to 10 ppm.

The present invention still further provides a method for producing a superconductive wire, wherein the powders for constituting magnesium diboride are of elemental magnesium and boron.

### BRIEF DESCRIPTION OF DRAWINGS

Fig. 1 is a schematic illustration showing superconductive wire production equipment.
Fig. 2A is a photograph showing a section of an MgB₂ superconductive wire (1.0 mm in diameter) and Fig. 2B is a schematic illustration showing a section of the MgB₂ superconductive wire.
Fig. 3 is a graph showing the superconductive characteristic of an MgB₂ superconductive wire (Ar gas content 0.00002 ppm).
Fig. 4 is a graph showing the superconductive characteristic of an MgB₂ superconductive wire (Ar gas content 10 ppm).
Fig. 5 is a graph showing the relationship between an Ar gas content and a burn-out rate of an MgB₂ superconductive wire.
Fig. 6 is a view showing the superconductive characteristic of an MgB₂ superconductive wire (0.2 mm in diameter).
Figs. 7A to 7F are views explaining a method for producing a superconductive wire.

### DETAILED DESCRIPTION OF THE PREFERRED EMBODIMENTS

Embodiments are hereunder explained in reference to drawings.

### (Superconductive wire)

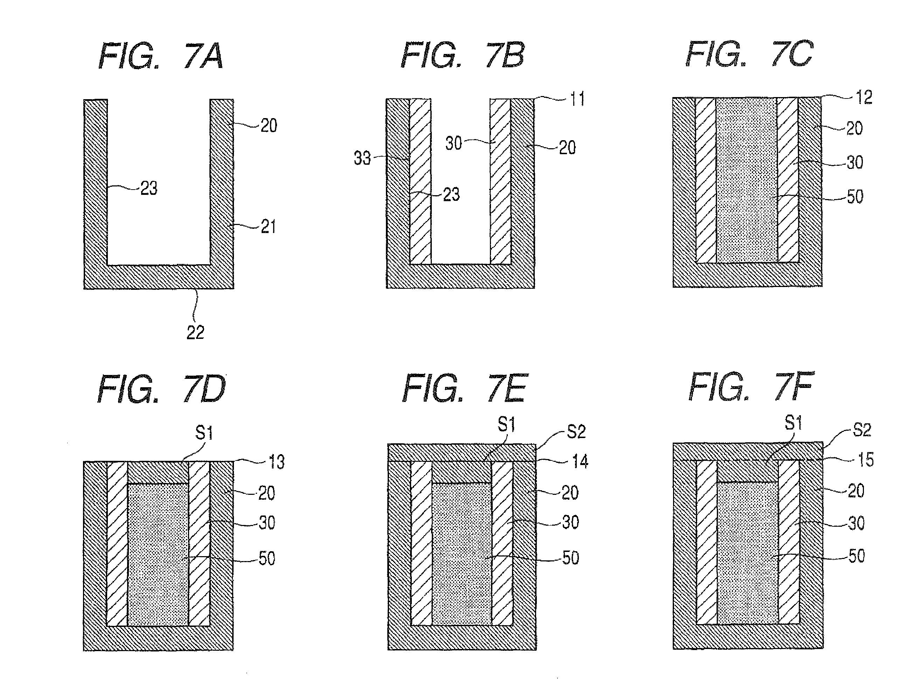

A metallic pipe used in the present embodiment is explained in reference to Figs. 7A to 7F.

As shown in Fig. 7B, a metal-made filling pipe 11 has a dual structure comprising an outer pipe 20 functioning as a stabilizing layer and an inner pipe 30 functioning as an interrupting layer.

In the present embodiment, the outer pipe 20 is structured so as to have a cylinder portion 21 and a bottom portion 22 disposed on the side of an end in the manner of closing the end as shown in Fig. 7A. That is, the outer pipe 20 forms a closed-end cylinder. A typical example thereof is a cylindrical body. Further, the bottom portion 22 is not limited to a flat plate but may take the shape of a frustum. As the material, Cu, Al, Ag, or Au is used for example. It goes without saying that the material is not limited to those metals. Further, the structure of a closed end may also be formed by attaching a bottom plate or a plugging member to an end of a pipe. Or otherwise, a closed-end cylinder may be produced by forming a plate into a deep-hole structure.

As the inner pipe 30, a pipe both the ends of which are open is used in the present embodiment. The inner pipe 30 is inserted into the outer pipe 20. On this occasion, the outer diameter of the inner pipe 30 is formed so that the outer circumferential surface 33 of the inner pipe 30 may touch the inner circumferential surface 23 of the outer pipe 20. As the material for the inner pipe 30, for example Nb, Ti, Cr, Fe, Ni, Zr, or Ta is used. Both the ends of the inner pipe 30 may be open. It goes without saying that the inner pipe 30 may be structured so that an end thereof may open in the same manner as the aforementioned outer pipe 20.

### (With regard to equipment to produce a superconductive wire)

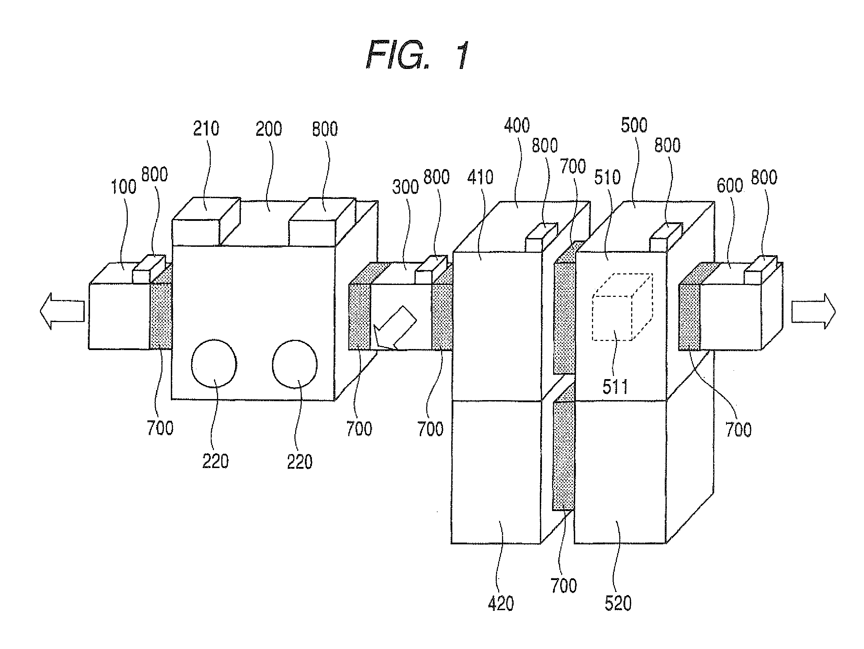

Firstly equipment to produce a superconductive wire is explained. In the present embodiment, superconductive wire production equipment (refer to Fig. 1) is used for producing a superconductive wire.

A schematic illustration of superconductive wire production equipment is shown in Fig. 1. The superconductive wire production equipment shown in Fig. 1 is provided with a powder storage room 100, a powder conditioning room 200, an intermediate preparation room 300, a vacuum filling room 400, a vacuum sealing room 500, and a filled pipe extraction room 600. Each of the powder storage room 100 to the filled pipe extraction room 600 is structured in the form of a vacuum chamber. In each room, a vacuum environment is obtained with a vacuum system 800 having a vacuum pump and others. Further, all the rooms from the powder storage room 100 to the filled pipe extraction room 600 are communicated with each other in sequence so that a specimen may be transferred in the interiors. Furthermore, gate valves 700 are disposed between adjacent two rooms of the powder storage room 100 to the filled pipe extraction room 600 respectively. A transfer machine not shown in the figure is used for the transportation of a specimen.

The powder storage room 100 stores powder 50 of magnesium diboride or a source material constituting magnesium diboride. In the present embodiment, the degrees of vacuum are predetermined in the powder storage room 100 and powder is stored in accordance with each degree of vacuum. Further, in order to save weighing in the powder conditioning room 200, a required quantity of powder to be used is measured beforehand, contained in a container, and stored. It goes without saying that a configuration wherein powder to be used is weighed in the powder conditioning room 200 may be adopted.

The powder conditioning room 200 carries out the process of mixing powder 50 of magnesium diboride or a source material constituting magnesium diboride stored in the powder storage room 100 in conformity with an intended superconductive wire and thus conditions the powder 50 of magnesium diboride or a source material constituting magnesium diboride for the wire. A vacuum system 800 to exhaust a gas and a gas inlet system 210 to introduce a gas such as an Ar gas into the interior are connected to the powder conditioning room 200. Further, glove holes 220 to which gloves for operation are attached are disposed on the powder conditioning room 200.

In the powder conditioning room 200, the pressure is reduced with the vacuum system 800 and thereafter a replace gas such as an Ar gas is introduced through the gas inlet system 210. In the state, the powder 50 of magnesium diboride or a source material constituting magnesium diboride is conditioned.

In the present embodiment, the intermediate preparation room 300 is located between the powder conditioning room 200 and the vacuum filling room 400. The intermediate preparation room 300 is configured so as to be partitioned by gate valves 700 at the interface with the powder conditioning room 200 and at the interface with the vacuum filling room 400 , respectively. Here, the intermediate preparation room 300 not only functions as a preparation room to absorb the difference between the degree of vacuum in the powder conditioning room 200 and the degree of vacuum in the vacuum filling room 400 but also can take in and out a specimen and others from and to the exterior, if needed.

In the vacuum filling room 400, a pipe 11 prepared for filling, more specifically a filling pipe 11 having the structure shown in Fig. 7B, is filled with the conditioned powder 50 of magnesium diboride or a source material constituting magnesium diboride. In the present embodiment, a metallic filling pipe 11 is formed by covering an inner pipe 30 with an outer pipe 20. For example, a Nb pipe is used as the inner pipe 30 and a Cu pipe is used as the outer pipe 20. Consequently, a dual-structured pipe is used in the present embodiment.

The filling is carried out in the state of powder. Since the vacuum filling room 400 is in a vacuum environment, the filling is carried out while a replaced gas absorbed in the powder is removed.

Otherwise, powder may be formed into a bar by applying pressure and heat to the powder and thereafter a filling pipe 11 may be filled with the bar-shaped powder.

The vacuum filling room 400 has an upper chamber 410 and a lower chamber 420. The filling pipe 11 (Fig. 7B) is fixed in the lower chamber 420. The upper chamber 410 is provided with a tapping device (not shown in the figure). The filling of powder is carried our by dropping the powder from the upper chamber 410 to the filling pipe 11 (Fig. 7B) fixed in the lower chamber 420. The filling pipe 11 is filled with the powder and a powder-filled pipe 12 (Fig. 7C) is formed.

In the vacuum sealing room 500, the powder-filled pipe 12 is capped with a plug S in a vacuum environment and subjected to heat treatment. For the purpose, the vacuum sealing room 500 has an upper chamber 510 for heat treatment and a lower chamber 520 for vacuum sealing. The upper chamber 510 is provided with a heat-treating furnace 511.

In the lower chamber 520, the plug S is attached to the open end of the powder-filled pipe 12. As the plug S, for example, a bar S1 to be inserted into the filled pipe 12 as shown in Fig. 7C and a lid S2 to seal the end after the bar S1 is inserted are used (Figs. 7D and 7E). A brazing filler material for sealing is attached to the lid S2 beforehand.

The pipe 14 to which the plug is attached is transferred from the lower chamber 520 with an elevator (not shown in the figure) or the like and sealed by subjected to heat treatment (maximum temperature: 1,000ºC) in the heat-treating furnace 511 in the upper chamber 510, and thereby a vacuum-sealed pipe 15 is formed.

In the present embodiment, the brazing of the lid S2 to the filled pipe 12 may be applied either to the Cu pipe as the outer pipe of the dual structure or to the Nb pipe as the inner pipe. For example, it is possible to select brazing of a lower temperature.

The procedure of the plug attachment is as follows. Firstly, a bar S1 is inserted by pressure into the powder-filled pipe 12 (Fig. 7D). Thereafter a lid S2 is attached to the pipe 13 into which the bar is inserted by pressure (Fig. 7E).

Here on this occasion, the attachment of the bar may be omitted. However, a vacuum-sealed pipe 15 (Fig. 7F) having a better degree of vacuum can be producedwhen the bar is attached.

In the filled pipe extraction room 600, whether or not leakage occurs at the seal of the vacuum-sealed pipe 15 is checked and the vacuum-sealed pipe 15 can be extracted. For example, a helium gas is used for the check of the leakage from the seal.

The gate valves 700 are used for opening and closing valves when a specimen is transferred and keeping the degree of vacuum in each room.

### (Method for producing a superconductive wire)

A method for producing a superconductive wire is hereunder explained with production equipment shown in Fig. 1.

Firstly, powder 50 of magnesium diboride or a source material constituting magnesium diboride is measured and a necessary amount thereof is contained in a container and stored in the powder storage room 100 beforehand.

Successively, in the powder conditioning room 200, a ball mill pot sealed with a vacuum is unsealed. The ball mill pot is filled with the powder 50 of magnesium diboride or a source material constituting magnesium diboride measured and stored in advance. The powder 50 of magnesium diboride or a source material constituting magnesium diboride is mixed in the ball mill pot by rotating the ball mill pot with a ball mill apparatus in a replace gas environment. Here, the powder may be mixed also in a vacuum environment.

Then the mixed powder 50 of magnesium diboride or a source material constituting magnesium diboride is transferred to the upper chamber 410 in the vacuum filling room 400 via the intermediate preparation room 300. Meanwhile, in the lower chamber 420, the aforementioned filling pipe 11 (Fig. 7B) is prepared. More specifically, a pipe used for filling is selected from among plural filling pipes 11 arranged in advance and is ready for filling.

In the state, in the upper chamber 410, the mixed powder 50 of magnesium diboride or a source material constituting magnesium diboride is dropped into the filling pipe 11 prepared in the lower chamber 420 with a tapping apparatus and the filling pipe 11 is filled with the powder. On this occasion, the upper and lower chambers 410 and 420 are in the state of a vacuum environment with the vacuum system 800. Consequently, since an Ar gas or the like is evacuated during filling, the filling pipe 11 is filled with the magnesium diboride powder 50 dropped into the filling pipe 11 in the state of not confining the gas.

Successively, the powder-filled pipe 12 (Fig. 7C) is transferred to the lower chamber 520 in the vacuum sealing room 500 via a gate valve 700.

In the lower chamber 520, a plug S is attached to the open end of the filled pipe 12. As the plug S, for example, a bar S1 to be inserted into the filled pipe 12 as shown in Fig. 7C and a lid S2 to seal the end after the bar S1 is inserted are used (Figs. 7D and 7E). For example, a Cu bar is used as the bar S1 and a Cu lid is used as the lid S2. A brazing filler material for sealing is attached to the lid S2 beforehand. As the brazing material, Ag brazing material can be used for example.

In the present embodiment, the brazing of the lid to the filled pipe 12 may be applied either to the Cu pipe as the outer pipe of the dual structure or to the Nb pipe as the inner pipe. For example, it is possible to select brazing of a lower temperature.

The procedure of the plug S attachment is as follows. Firstly, a bar S1 is inserted by pressure into the pipe 12 filled with the powder 50 of magnesium diboride or a source material constituting magnesium diboride (Fig. 7D). Thereafter a lid S2 is attached (Fig. 7E).

Here on this occasion, the attachment of the bar may be omitted. However, a vacuum-sealed pipe 15 having a better degree of vacuum can be produced when the bar S1 is attached.

In the heat-treating furnace 511 in the upper chamber 510, the tip of the pipe 14 to which the plug is attached is heated and brazed and thereby the whole pipe is sealed with a vacuum. By so doing, the vacuum-sealed pipe 15 that is a filled pipe sealed with a vacuum is produced.

Thereafter the vacuum-sealed pipe 15 is extracted from the heat-treating furnace 511 and transferred to the filled pipe extraction room 600.

The vacuum-sealed pipe 15 is extracted from the filled pipe extraction room 600 and wiredrawn. It is desirable to enhance the vacuum sealing by further working both the ends of the vacuum-sealed pipe with a swage before the wiredrawing. Thereafter, the pipe is wiredrawn with a drawbench and thinned until the whole diameter is reduced to a target value, for example 1.0 mm in diameter. On this occasion, it is possible to apply not swage working but wiredrawing.

### (Examples)

Examples are hereunder explained.

Firstly, in the powder storage room 100 of a production apparatus shown in Fig. 1, a container containing powder 50 of magnesium diboride or a source material constituting magnesium diboride is stored as preparation. As the powder 50 of magnesium diboride or a source material constituting magnesium diboride, commercially available Mg and B are used. A necessary amount of the powder 50 of magnesium diboride or a source material constituting magnesium diboride is measured beforehand so that the contents of Mg and B may take the stoichiometric composition (ratio is 1:2), contained in the container, and stored in the powder storage room 100.

In the powder conditioning room 200 , a ball mill pot sealed with a vacuum is unsealed and the ball mill pot is filled with the powder Mg and B measured and stored in the powder storage room 100.

Thereafter, the powder 50 of magnesium diboride or a source material constituting magnesium diboride is mixed with a ball mill. On this occasion, the degree of vacuum is 1.0 x 10⁻⁴ Torr. Thereafter, the Mg + B powder mixed with the ball mill is transferred to the upper chamber 410 in the vacuum filling room 400 via the intermediate preparation room 300.

Successively, in the vacuum filling room 400, the filling pipe 11 (Fig. 7B) prepared in the lower chamber 420 is filled from the upper chamber 410 with the Mg + B powder mixed with the ball mill in a vacuum environment. Then the pipe 12 filled with the Mg + B powder (Fig. 7C) is transferred to the lower chamber 520 in the vacuum sealing room 500.

In the lower chamber 520, a plug S (a bar S1 and a lid S2) is attached to the open end of the filled pipe 12 and thereby the pipe 14 to which the plug is attached (Fig. 7E) is formed. A Cu bar is used as the bar S1 and a Cu lid is used as the lid S2. As the brazing material applied to the lid S2 beforehand for sealing, an Ag brazing material is used. The brazing of the lid S2 to the filled pipe 12 is applied to the Cu pipe as the outer pipe of the dual structure in the present embodiment.

The pipe 14 to which the plug is attached is transferred to the upper chamber 510 having the heat-treating furnace 511. Then in the heat-treating furnace 511, the tip of the pipe 14 to which the plug S is attached is heated and the whole pipe is sealed with a vacuum. By so doing, the vacuum-sealed pipe 15 that is a filled pipe sealed with a vacuum is produced.

Thereafter the vacuum-sealed pipe 15 is extracted from the heat-treating furnace 511 and transferred to the filled pipe extraction room 600.

After leakage from the vacuum-sealed pipe 15 (Fig. 7F) is checked, the vacuum-sealed pipe 15 is extracted from the filled pipe extraction room 600 and subjected to wiredrawing.

Then the vacuum- sealed pipe 15 is extracted from the filled pipe extraction room 600 into the air. Thereafter, the vacuum-sealed pipe 15 is put into a storage box and transferred. Then both the ends of the vacuum-sealed pipe 15 are further processed with a swage and the vacuum-sealing is further strengthened. Then the vacuum-sealed pipe 15 is wiredrawn with a drawbench and thinned until the whole diameter reaches 1.0 mm.

Here, initial dimensions of the two metallic pipes constituting a Cu-Ni dual-structured metallic pipe used for producing an MgB₂ superconductive wire in the present embodiment are as follows;
stabilizing layer: Cu pipe, 18 mm in outer diameter, 16 mm in inner diameter, 500 mm in length,
interrupting layer: Nb pipe, 15 mm in outer diameter, 13 mm in inner diameter, 500 mm in length.

### (Evaluation of an MgB₂ superconductive wire produced in the present embodiment)

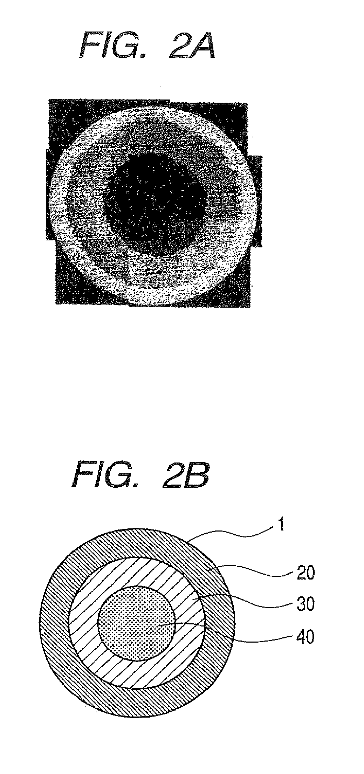

A photograph of a section of an MgB₂ superconductive wire produced in the present invention is shown in Fig. 2A and a schematic illustration thereof is shown in Fig. 2B. The MgB₂ superconductive wire 1 in Fig. 2 is structured so as to have an outer pipe 20, an inner pipe 30, and a core portion 40 where MgB₂ is solidified.

The gas content in the MgB₂ superconductive wire produced in the present embodiment was measured and resultantly the content of an Ar gas could be reduced to 0.00002 ppm. Likewise, the contents of other gasses such as O₂ and H₂O were measured and similar reduced gas contents could be obtained.

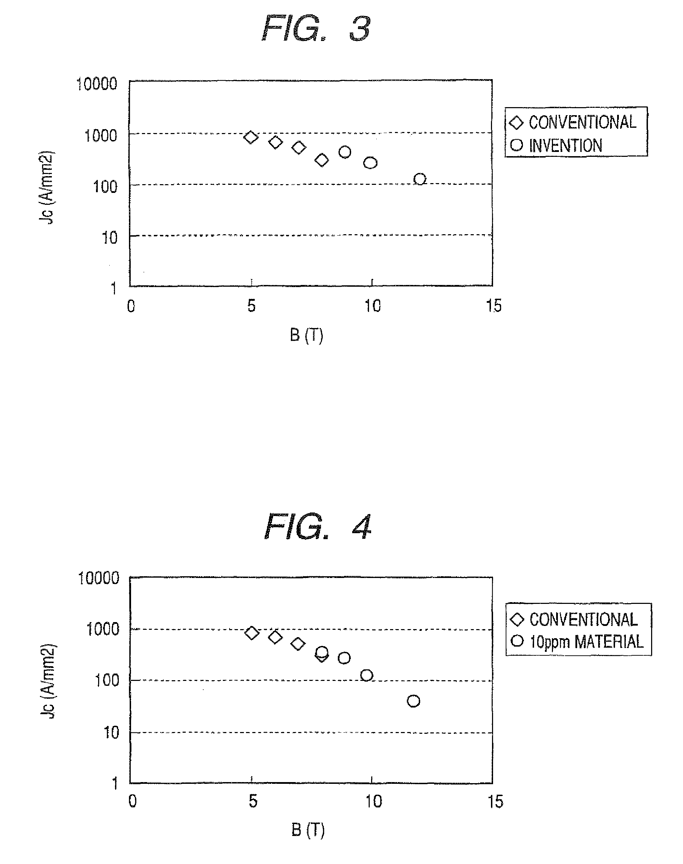

Successively, critical current of the MgB₂ superconductive wire (Ar gas content: 0.00002 ppm) produced in the present embodiment was measured. The result is shown in Fig. 3. In Fig. 3, the measurement result of the MgB₂ superconductive wire produced in the present embodiment is shown with open quadrangles. Then for comparison, an MgB₂ superconductive wire was produced by a conventional method and the result of the measurement of the critical current of the MgB₂ superconductive wire produced by the conventional method is shown with lozenges in Fig. 3. The critical current of a wire was measured by using a general direct current four-terminal method and immersing the whole specimen in liquid helium.

From Fig. 3, it was found that the MgB₂ superconductive wire produced in the present embodiment showed magnetic field dependency. Further it was found that the magnetic field characteristic of the MgB₂ superconductive wire produced in the present embodiment was superior to that of the MgB₂ superconductive wire produced by the conventional method.

Successively, since the degree of vacuum could be adjusted during filling, an MgB₂ superconductive wire having an Ar gas content of 10 ppm was produced and the critical current was measured. The result is shown with round circles in Fig. 4. From Fig. 4, it was found that a magnetic flux density almost equal to the maximum magnetic flux density realizing in an MgB₂ wire produced by a conventional method could be obtained. From the result, it was found that it was important to reduce an Ar gas content to less than 10 ppm.

A degree of vacuum and a gas content were adjusted with the aim of reducing an Ar gas content to less than 0.00002 ppm but it was unsuccessful because powder was hardly packed due to powder scattering and also the degree of vacuum was hardly adjustable.

In view of the above situation, it was found that practically the properties of an MgB₂ superconductive wire improved when an Ar gas content was in the range of 0.00002 to 10 ppm.

In the present embodiment as stated above, Mg + B powder is packed in the vacuum filling room 400 and a vacuum-sealed pipe 15 is formed in the vacuum sealing room 500. When the Mg + B powder is packed, the air is evacuated into vacuum. Consequently, the gas around the packed Mg + B powder is thin and thus the gas is very unlikely to be embraced. As a result, it was possible to reduce the volume of the gas contained in the packed Mg + B powder to the minimum in a filled pipe 12. Further, since the chemical combination with the ambient gas also reduced, the contamination and the oxidation of the used powder could be suppressed. Consequently, it could be said that the possibility of largely reducing the content of a gas causing wire breakage and performance on critical current to deteriorate when a superconductive wire was lengthened increased.

Even when filling is carried out in an Ar atmosphere, the content of the Ar gas may sometimes reduce. Mostly such a case occurs accidentally and hence the yield lowers in the case of mass production. On the other hand, in the present invention, since powder 50 of magnesium diboride or a source material constituting magnesium diboride is packed under a vacuum environment, it comes to be possible to reduce an Ar content not accidentally but inevitably. As a result, a very low Ar gas content can be realized as shown in the present embodiment and hence it is possible to improve the yield.

Further, when wiredrawing is applied, it is possible to control the volume of a gas contained in a vacuum-sealed pipe 15 so as to be reduced. When a gas content is low, the fluidity of powder improves at filling and the amount of the gas interposing between particles is also low. Consequently, the contact areas between particles increase and densification advances. As a result, it is possible to reduce the rate of wire breakage caused by the gas contained in a core portion and prevent densification from being interrupted.

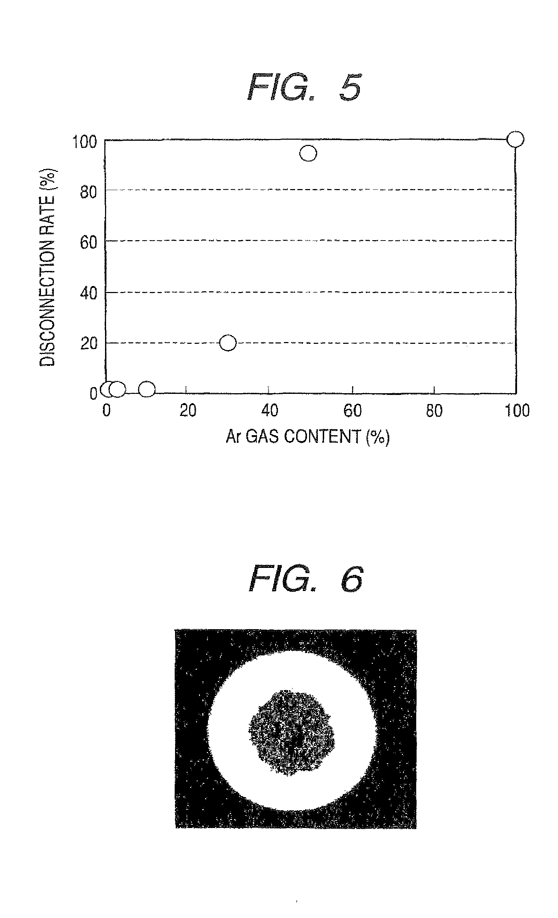

Further, the relationship between an Ar gas content and a burn-out rate of an MgB₂ superconductive wire is shown in Fig. 5. It was found that the method for producing an MgB₂ superconductive wire according to the present invention could considerably reduce a burn-out rate from Fig. 5 and from the fact that the Ar gas content in the MgB₂ superconductive wire produced according to the present invention was in the range of 0.00002 to 10 ppm.

### (Case where further thinning is applied)

An MgB₂ superconductive wire produced in the present embodiment was further thinned to a diameter of 0.2 mm. A photograph of a section of an MgB₂ superconductive wire thinned to a diameter of 0.2 mm is shown in Fig. 6. From Fig. 6, it was found that the produced MgB₂ superconductive wire could be wiredrawn up to 0.2 mm in diameter without breakage.

Further, the wire was wound non-inductively around a metallic bobbin and the critical current of the long wire was measured. Resultantly, the result showed the same characteristics as those of a short wire. Thereby it was found that the wire had uniformity in the longitudinal direction.

From the above results, it was found that the properties of an MgB₂ superconductive wire improved by producing the wire in a vacuum and thus reducing the gas content in the MgB₂ superconductive wire. Further, it was found that the workability in lengthy wiredrawing also improved.

### (Other embodiments: applicable to other materials)

Since it is important for the production method of an MgB₂ superconductive wire according to the present invention to keep vacuum sealing while used powder is prevented from touching the external air from the powder packing step to the wiredrawing step, it is obvious that a high-performance superconductive wire can be obtained even when the following modifications are made.
1) To apply MgB₂ powder, in place of Mg + B powder, to a filling pipe.
2) To apply a single-structured pipe of Cu or the like in place of a Cu + Nb dual-structured pipe.
3) The number of core filaments of an MgB₂ wire is not single but plural.

### (With regard to higher performance)

Meanwhile, as methods for improving the performance of an MgB₂ wire, the following methods can be considered.
1) Before powder mixing, commercially available powder is ground with a vacuum mixing apparatus and thereafter mixed at a prescribed ratio. In the mixing ratio of Mg + B powder, the ratio of B is controlled to not less than twice the ratio of Mg.
2) Before mixing and grinding commercially available powder, water is removed by sufficiently drying it.

In any of those cases, the reaction of MgB₂ is accelerated and hence the methods are very effective. Further, even when MgB₂ powder is used, the performance of a wire can be improved by increasing current paths due to the exposure of the fresh surfaces of the powder and removing moisture on the surfaces.

With regard to vacuum sealing methods, not only the aforementioned brazing method but also a vacuum bonding method such as electron beam welding (EBW) and a friction bonding method such as friction stir welding (FSW) can exhibit similar effects. Further, although similar effects can be obtained by evacuating a gas into a vacuum in a pipe after welding is once applied in an Ar gas or the like, the danger of residual gas exists and hence vacuum sealing is most effective.

In the present embodiment, when a superconductive wire is produced, a metallic pipe is filled with powder 50 of magnesium diboride or a source material constituting magnesium diboride in a vacuum environment and sealed in the vacuum environment. Further, it is possible to keep the material powder 50 in the state of vacuum sealing with the vacuum-sealed pipe 15 so as not to touch a gas outside the pipe until wiredrawing is finished. Consequently, it is possible to considerably reduce the content of a gas that causes wire breakage and performance related to critical current to deteriorate. Furthermore, it is possible to improve performance and densify of the core portion effectively by area reduction with a drawbench. As a result, it comes to be possible to produce a high-density high-performance superconductive wire.

## Claims

1. A superconductive wire wherein
said superconductive wire has a core portion containing magnesium diboride as the main component and a continuous metallic sheath firmly adhered to said core portion;
said core portion is kept substantially vacuum; and
the content of an inert gas contained in the core portion is in the range of 0.00002 to 10 ppm.

2. The superconductive wire according to Claim 1, wherein said inert gas is an Ar gas.

3. A method for producing a superconductive wire, comprising the steps of:
mixing powder of a source material (hereunder referred to as material powder) constituting magnesium diboride to form a core portion of said superconductive wire in an inert gas;
filling a pipe with said mixed material powder in a vacuum environment;
sealing said pipe with a vacuum after filled with said material powder;
forming magnesium diboride powder by heating said vacuum-sealed pipe; and
forming said core portion by wiredrawing said pipe in the state where said magnesium diboride powder is sealed with a vacuum, so that said core portion firmly sticks to the wiredrawn metallic pipe, said core portion is kept substantially vacuum, and the content of an inert gas contained in the core portion is in the range of 0.00002 to 10 ppm.

4. A method for producing a superconductive wire, comprising the steps of:
filling a pipe with powder containing magnesium diboride as the main component to form a core portion of said superconductive wire in an inert gas;
replacing said inert gas in said pipe with vacuum;
sealing said metallic pipe with vacuum after filling said pipe with said powder containing magnesium diboride as the main component and replacing said inert gas with vacuum; and
forming said core portion containing magnesium diboride as the main component by wiredrawing said metallic pipe in the state where said powder containing said magnesium diboride as the main component is sealed with vacuum, so that said core portion firmly sticks to said wiredrawn metallic pipe, said core portion is kept substantially vacuum, and the content of said inert gas contained in the core portion is in the range of 0.00002 to 10 ppm.

5. The method for producing a superconductive wire according to Claim 4, wherein said inert gas is an Ar gas.

6. The method for producing a superconductive wire according to claim 3, wherein the powder is elemental magnesium and boron.
